(19) **Europäisches Patentamt / European Patent Office / Office européen des brevets**

(11) **EP 4 078 291 B1**

(12) **FASCICULE DE BREVET EUROPEEN**

(45) Date de publication et mention de la délivrance du brevet:
**15.11.2023  Bulletin 2023/46**

(21) Numéro de dépôt: **20833928.3**

(22) Date de dépôt: **29.12.2020**

(51) Classification Internationale des Brevets (IPC):
**G03F 7/00** *(2006.01)*   **B82Y 40/00** *(2011.01)*

(52) Classification Coopérative des Brevets (CPC):
**G03F 7/0002;** B82Y 40/00

(86) Numéro de dépôt international:
**PCT/EP2020/088007**

(87) Numéro de publication internationale:
**WO 2021/136794 (08.07.2021 Gazette 2021/27)**

(54) **PROCEDE DE NANOSTRUCTURATION D'UN SUBSTRAT**

VERFAHREN ZUM NANOSTRUKTURIEREN EINES SUBSTRATS

METHOD FOR NANOSTRUCTURING A SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.12.2019  FR 1915802**

(43) Date de publication de la demande:
**26.10.2022  Bulletin 2022/43**

(73) Titulaires:
• **ARKEMA FRANCE**
**92700 Colombes (FR)**
• **Centre National de la Recherche Scientifique**
**75016 Paris (FR)**
• **Université Grenoble Alpes**
**38400 Saint-Martin-d'Hères (FR)**

(72) Inventeurs:
• **CHEVALIER, Xavier**
**38100 Grenoble (FR)**
• **ZELSMANN, Marc**
**38330 Biviers (FR)**
• **NAVARRO, Christophe**
**64100 Bayonne (FR)**
• **POUND-LANA, Gwenaëlle**
**38000 Grenoble (FR)**

(74) Mandataire: **A.P.I. Conseil**
**Immeuble Newton**
**4, rue Jules Ferry**
**64000 Pau (FR)**

(56) Documents cités:
**US-A1- 2015 261 090**

## Description

[Domaine de l'invention]

La présente invention concerne le domaine de la nano-lithographie par auto-assemblage dirigé, encore appelée DSA (de l'acronyme anglais «Directed Self-Assembly »).

Plus particulièrement, l'invention se rapporte à un procédé de fabrication d'un film de copolymère à blocs destiné à être utilisé en tant que masque de nano-lithographie et comprenant des motifs de périodes différentes pour la nanostructuration d'un substrat présentant des nanostructures de dimensions différentes.

[Art antérieur]

Les copolymères à blocs (BCPs) constituent depuis les années 1960 un champ de recherche très vaste pour le développement de nouveaux matériaux. Il est possible de moduler et contrôler leurs propriétés par la nature chimique des blocs et leur architecture pour l'application visée. Pour des paramètres macromoléculaires ($M_n$, $I_p$, $f$, $\chi$, N) spécifiques, les copolymères à blocs sont capables de s'auto-assembler et former des structures dont les dimensions caractéristiques (10 -100nm) constituent aujourd'hui un enjeu majeur dans le domaine de la microélectronique et des systèmes micro-électro-mécaniques (MEMS).

Dans le cadre particulier des applications dans le domaine de la nano-lithographie par autoassemblage dirigé, ou DSA (acronyme anglais pour « Directed Self-Assembly »), les copolymères à blocs, aptes à se nano-structurer à une température d'assemblage, sont utilisés en tant que masques de nano-lithographie. Les copolymères à blocs, une fois nano-structurés, permettent d'obtenir des cylindres, lamelles, sphères ou encore des gyroïdes qui forment respectivement des motifs, pour la création de masques de nano-lithographie, avec une périodicité pouvant être inférieure à 20 nm, qu'il est difficile d'atteindre avec les techniques de lithographies conventionnelles. Cette périodicité est très appréciable lorsque l'on souhaite créer des nanostructures présentant toutes la même dimension, afin d'obtenir des propriétés (conductivité électrique, dissipation thermique etc...) identiques pour différentes structures isolées spatialement sur un substrat.

Cependant, les masques de nano-lithographie existants comportent en général un seul motif répétitif sur toute leur surface. Or, pour des applications particulières, il peut être intéressant de réaliser un masque avec des motifs dont la période varie, pour les transférer dans un substrat sous-jacent. En particulier, pour certaines applications en microélectronique, on cherche à réaliser des films de copolymères à blocs dans lesquels les motifs créés présentent des périodes différentes, tout en présentant un minimum de défauts, les dimensions des motifs allant de moins de 10 nm à environ 100 nm et pouvant être transférés dans un substrat sous-jacent par gravure sèche.

Ainsi, il a été proposé, lorsque l'on souhaite réaliser des structures de périodes différentes, de disposer de plusieurs copolymères à blocs de périodes différentes, les dispenser, les assembler chacun séparément, les graver, etc... augmentant considérablement le coût, et diminuant ainsi énormément la productivité globale du procédé, et donc son attractivité en termes de technique de structuration.

Il est donc souhaitable de pouvoir réaliser des motifs de périodes différentes dans un seul film de copolymère à blocs, le tout sans générer de défauts dans l'assemblage du copolymère à blocs. Ce dernier point est particulièrement délicat à réaliser. En effet, plus le copolymère à blocs sera contraint de s'écarter de sa période naturelle d'équilibre, plus il aura tendance à générer des structures défectueuses, la contrainte étant alors équivalente à une compression ou une dilatation des domaines s'orientant naturellement.

Différents systèmes de copolymères à blocs existants dans la littérature pourraient répondre à cette problématique de multi-périodicité, tels que par exemple :

- Les copolymères à blocs multiblocs, tels que décrits dans l'exemple de Yutaka Nagata et al., Macromolecules, 2005, 38,24, 10220-10225, peuvent présenter des périodes variables grâce à la propriété des chaines polymères à former des boucles au sein des domaines de l'assemblage final. Il s'agit toutefois de périodes « discrètes », dépendantes de la taille des différents blocs en question. Il est également à noter que plus le nombre de blocs augmente dans un copolymère à blocs, plus la cinétique d'auto-organisation est ralenti, limitant donc la possibilité d'une structure sans défaut dans un temps raisonnable.

- Les copolymères à blocs de structure différentes, multiblocs en étoile par exemple. Ces copolymères à blocs présentent cependant les mêmes inconvénients que les copolymères à blocs multiblocs décrits ci-dessus et leur synthèse s'avère très délicate.

- Les mélanges de copolymères à blocs avec différents additifs (copolymères à blocs, homopolymères, petites molécules...) semblent être une approche intéressante, d'autant plus que les dimensions finales ne seront pas nécessairement discrètes.

Dans le cadre de la nano-lithographie par auto-assemblage dirigé de copolymères à blocs BCPs, on cherche à obtenir un film de copolymère à blocs plan, c'est-à-dire non démouillé, présentant des nano-domaines perpendiculaires afin de pouvoir transférer ces nano-domaines dans le substrat sous-jacent pour créer des motifs de dimensions contrôlées, utiles pour des applications en microélectronique. Pour répondre à ces problématiques, la demanderesse a montré, dans les demandes de brevet FR 3 074 180 et FR 3 074 179, que la réticulation de films de « top-coats » TCs, d'affinité neutre vis-à-vis des blocs du copolymère à blocs sous-jacent, permettait d'obtenir des films de copolymères à blocs et de top coat plans, grâce à la contrainte mécanique imposée par la réticulation du top-coat. Pour cela, un activateur de réticulation, tel qu'un acide photogénéré (PAG), une base photogénérée (PBG) ou un générateur de radicaux par exemple, est incorporé au matériau de top coat et une stimulation appropriée de l'activateur, par un rayonnement UV ou un faisceau d'électrons ou encore un traitement thermique par exemple, permet de réticuler le film de top-coat.

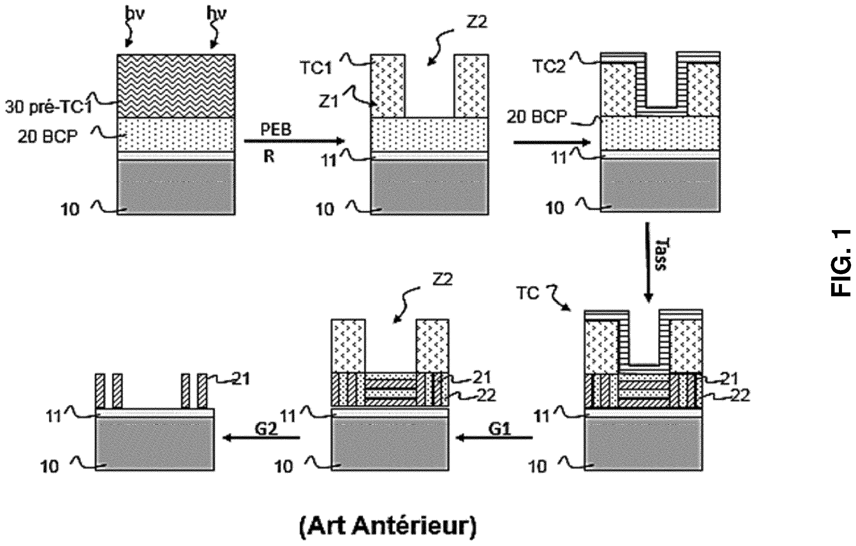

Ces documents décrivent en outre qu'une telle réticulation du film de top coat peut être réalisée de manière localisée, à travers un masque de lithographie, afin d'obtenir une réticulation localisée du top coat avec des zones réticulées et neutres vis-à-vis des blocs du copolymère à blocs sous-jacent, référencées Z1 sur la Figure 1, et des zones non réticulées Z2. Une telle réticulation localisée a pour but de créer des zones spécifiques dans le copolymère à blocs 20 sous-jacent, situées sous les zones neutres réticulées Z1 du top coat TC1, où les nanodomaines sont orientés perpendiculairement à la surface du substrat après recuit à la température d'assemblage. Toutefois, dans ce cas, le procédé suivi pour créer des zones spécifiques du BCP où les nano-domaines sont orientés perpendiculairement à la surface du substrat, est lourd à mettre en oeuvre. En effet, après l'étape de lithographie, permettant de réticuler localement certaines zones Z1 du top coat TC1, il est nécessaire de retirer les zones non-irradiées Z2 et donc non réticulées de matériau de top coat TC1, puis de re-remplir celles-ci avec un deuxième top coat TC2 d'affinité opposée au premier (c'est-à-dire que si le premier TC1 est neutre, alors le deuxième TC2 est non-neutre, et vice-versa), et réticuler ce deuxième top coat TC2 afin d'obtenir la planéité du film de copolymère à blocs 20 sous-jacent dans ces mêmes zones. Dans le cas contraire, si un deuxième top coat TC2 n'est pas utilisé puis réticulé afin d'assurer la planéité du film de BCP sous-jacent, le copolymère à blocs pourra être libre de démouiller de ces zones, ce qui peut être problématique lorsque des épaisseurs réduites du premier top coat 1 TC1 sont utilisées, typiquement lorsque l'épaisseur de TC1 est inférieure à deux fois celle du BCP sous-jacent. En outre, une première gravure G1 est nécessaire pour retirer la deuxième couche de top coat réticulée, puis une deuxième gravure G2 est nécessaire pour graver la couche de top coat résiduelle et enfin une troisième gravure est nécessaire pour transférer les motifs obtenus dans le substrat sous-jacent.

Le fait de déposer et réticuler deux top coat TC1 et TC2 d'affinité opposée vis-à-vis des blocs du copolymère à blocs permet de définir des zones avec des motifs orientés perpendiculairement aux interfaces et des zones avec des motifs orientés parallèlement aux interfaces dans un même film de copolymère à blocs. En variant la dimension des zones réticulées neutres et non neutre dans les deux couches de top coat TC1 et TC2, il est possible de définir des motifs parallèles et perpendiculaires, de dimensions variables, dans le copolymère à blocs sous-jacent. Cependant, un tel procédé comprend beaucoup d'étapes, si bien qu'il est long et coûteux à mettre en oeuvre.

La demanderesse a donc cherché une solution pour simplifier ce procédé et permettre la fabrication d'un film de copolymère à blocs comprenant des motifs de périodes différentes, notamment pour des applications dans le domaine de la microélectronique, offrant un plus large choix de masques pour la réalisation de semi-conducteurs ou circuits intégrés.

Dans ce contexte, la demande de brevet US 2015/261090 A1 divulgue un procédé d'alignement et d'orientation de copolymères à blocs comprenant : a) fournir un copolymère à blocs comprenant des unités répétitives de bloc A et de bloc B;

b) former sur un substrat une première couche comprenant un porteur d'agent réactif, ladite première couche étant neutre ou mouillant préférentiellement un des blocs;
c) former une couche du copolymère à blocs sur la première couche;
d) former une deuxième couche comprenant un porteur d'agent réactif sur ladite couche de copolymère à blocs, ladite deuxième couche étant neutre ou mouillant préférentiellement un des blocs , de manière à créer un assemblage;
e) irradier sélectivement cet assemblage selon un motif, les porteurs d'agent réactif irradiés fournissant l'agent réactif dans les régions sélectionnées de la première et de la deuxième couches de manière à modifier le mouillage préférentiel desdites régions sélectionnées, la diffusion de l'agent réactif augmentant la surface des régions sélectionnées; et
f) traiter ledit assemblage de manière à orienter et aligner le copolymère à blocs.

[Problème technique]

L'invention a donc pour but de remédier à au moins un des inconvénients de l'art antérieur. L'invention vise notamment à proposer un procédé simple et efficace pour fabriquer un film de copolymère à blocs destiné à servir de masque de nanolithographie pour la nanostructuration d'un substrat, ledit copolymère à blocs étant capable de se nano-structurer avec une seule période, ledit procédé permettant de réaliser, dans ledit film de copolymère à blocs, des motifs de périodes différentes, sans générer de défauts.

[Brève description de l'invention]

A cet effet, l'invention porte sur un procédé de nano-structuration d'un substrat pour la préparation d'un substrat nanostructuré présentant des nanostructures de dimensions différentes, ledit procédé comprenant les étapes suivantes :

- Génération d'une surface de guidage au-dessus d'un substrat;
- Dépôt d'une couche de copolymère à blocs non assemblé sur la surface de guidage, ladite couche de copolymère à blocs non assemblé étant apte à former, après assemblage, un copolymère à blocs nanostructuré sous forme de nanodomaines;
- Formation d'une couche polymérique réticulée au-dessus de la couche de copolymère à blocs non assemblé ;
- Recuit à une température correspondant à la température d'assemblage de la couche de copolymère à blocs non assemblé ;
- Retrait de la couche polymérique réticulée et d'un des blocs du copolymère à blocs nanostructuré de sorte à former des motifs d'un masque de nano-lithographie ;
- Gravure du substrat au moyen dudit masque de nano-lithographie ; ledit procédé étant caractérisé en ce que :

  - ladite surface de guidage comporte des zones neutres et des zones non neutres vis-à-vis de la couche de copolymère à blocs non assemblé, au moins une desdites zones neutres ou non neutres de la surface de guidage présentant une première dimension ;
  - ladite une couche polymérique réticulée comporte des zones neutres et des zones non neutres vis-à-vis de la couche de copolymère à blocs non assemblé, au moins une desdites zones non neutres de la couche polymérique réticulée présentant une deuxième dimension ;
  - ledit retrait d'un des blocs étant un retrait de seulement une partie des nanodomaines d'un des blocs du copolymère à blocs nanostructuré, en particulier de seulement les nanodomaines perpendiculaires dudit bloc, de sorte que les nanodomaines parallèles d'au moins deux blocs du copolymère à blocs nanostructuré forment des motifs du masque de nano-lithographie ; et
  - lesdites première et deuxième dimensions sont différentes de façon à générer dans le masque de nano-lithographie des motifs de dimensions différentes et des nanostructures dans le substrat nanostructuré de dimensions différentes après la gravure.

Le procédé selon l'invention permet de créer des dimensions différentes dans le masque de nano-lithographie indépendamment de la période naturelle du copolymère à blocs. En outre, le procédé permet d'utiliser les empilements formés de blocs parallèles au substrat, formés au niveau des zones non neutres comme une résine de lithographie puis de transférer ces motifs dans le substrat en même temps que ceux du copolymère à bloc.

Avantageusement, le procédé permet également de pouvoir varier à volonté la forme et les dimensions ainsi décrites dans le masque de nano-lithographie. Ainsi il est possible de multiplier les différentes dimensions pour un même motif adressées sur une même zone du substrat.

Par ailleurs, les zones non neutres de la surface de guidage et/ou de la couche polymérique réticulée prennent donc ici un intérêt particulier dans le cadre de l'invention. Ces zones issues de zones non neutres sont constituées des deux blocs du copolymère à blocs.

Selon d'autres caractéristiques optionnelles du procédé, ce dernier peut inclure facultativement une ou plusieurs des caractéristiques suivantes, seules ou en combinaison :

- la couche de copolymère à bloc non réticulée présente une épaisseur au moins égale à 10 nm ;
- la couche polymérique réticulée présente au moins une zone non neutre de dimension différente à celle de la zone neutre ;
- la génération d'une surface de guidage au-dessus d'un substrat implique la mise en oeuvre d'une chimie-épitaxie ou d'une grapho-épitaxie ;
- la surface de guidage comporte des surépaisseurs de résine de guidage et les surépaisseurs présentent des propriétés de gravure similaires à un des blocs du copolymère à bloc ;
- la résine de guidage formant les surépaisseurs est non neutre vis-à-vis du copolymère à bloc ;
- la résine de guidage formant les surépaisseurs est neutre vis-à-vis du copolymère à bloc ;
- la gravure de la résine de guidage est réalisée selon un mode positif ;
- la gravure de la résine de guidage est réalisée selon un mode négatif ;
- les zones du copolymère à blocs situées sous les zones neutres de la couche polymérique réticulée, présentent des nano-domaines orientés perpendiculairement aux interfaces et la dimension des nanodomaines correspond à la première dimension des zones non neutres
- les zones du copolymère à blocs situées sous les zones non neutres de la couche polymérique réticulée, présentent des nano-domaines orientés parallèlement aux interfaces et la dimension des nano-domaines correspond à la première dimension des zones non neutres;
- le copolymère à bloc comporte au moins un bloc où un hétéroatome tel que du silicium, du germanium, du titane, du hafnium, du zirconium, de l'aluminium dans tout ou partie des (co)monomères constitutifs dudit bloc ;
- la couche polymérique réticulée présente au moins deux zones non neutres de dimensions différentes.

Selon le procédé de l'invention,

- la formation d'une couche polymérique réticulée au-dessus de la couche de copolymère à blocs non assemblé comporte les sous-étapes suivantes :

  - Dépôt d'une première couche d'une composition pré-polymère sur la couche de copolymère à blocs non assemblé ;
  - Réaction de réticulation locale des chaines moléculaires au sein de ladite première couche de composition pré-polymère de façon à générer une couche polymérique localement réticulée ;
  - Rinçage de la couche polymérique localement réticulée afin de retirer les zones non réticulées ;
  - Dépôt d'une deuxième couche d'une composition pré-polymère au moins sur la couche de copolymère à blocs non assemblé ;
  - Réaction de réticulation locale des chaines moléculaires au sein de ladite deuxième couche d'une composition pré-polymère de façon à générer une couche polymérique réticulée.

Alternativement, le procédé selon l'invention prévoit que

- la formation d'une couche polymérique réticulée au-dessus de la couche de copolymère à blocs non assemblé comporte les sous-étapes suivantes :

  - déposer une couche de composition prépolymère comprenant d'une part, une pluralité de monomères fonctionnels et au moins un groupement fonctionnel réticulable au sein de sa chaine polymérique et d'autre part, deux agents de réticulation chimiquement différents, chaque agent étant apte à initier la réticulation dudit prépolymère en réponse à une stimulation qui lui est propre, et
  - opérer deux réticulations successives dans des zones primaires et secondaires de ladite couche, par stimulation successive des deux agents de réticulation, afin de provoquer une réaction de réticulation des chaines moléculaires dudit prépolymère par action successive du premier agent de réticulation dans lesdites zones primaires soumises à ladite première stimulation puis du deuxième agent de réticulation dans lesdites zones secondaires soumises à ladite deuxième stimulation afin d'obtenir une couche polymérique réticulée dans laquelle les différentes zones réticulées primaires et secondaires présentent une affinité opposée vis-à-vis des blocs du copolymère à blocs sous-jacent.

D'autres avantages et caractéristiques de l'invention apparaitront à la lecture de la description suivante donnée à titre d'exemple illustratif et non limitatif, en référence aux Figures annexées :

La figure 1 représente un schéma d'un procédé de nano-structuration d'un substrat selon l'art antérieur.
La figure 2 représente un schéma d'un procédé de nano-structuration d'un substrat selon un mode de réalisation de l'invention.
La figure 3 représente un schéma d'un procédé de nano-structuration d'un substrat selon un mode de réalisation de l'invention.
La figure 4 représente un schéma d'un procédé de nano-structuration d'un substrat selon un mode de réalisation de l'invention.

Dans la suite de la description, par « polymère » on entend soit un copolymère (de type statistique, à gradient, à blocs, alterné), soit un homopolymère.
Le terme « **prépolymère** » tel qu'utilisé se rapporte à au moins un monomère et/ou dimère et/ou oligomère et/ou un polymère présentant des groupes réactifs lui permettant de participer à une polymérisation ou réticulation ultérieure et d'incorporer ainsi plusieurs unités monomères dans au moins une chaine de la macromolécule finale.
On entend par « **chaine polymérique d'un prépolymère** », la chaine principale d'assemblage d'une pluralité d'unités monomères, d'autres chaines moins importantes étant considérées comme des ramifications de la chaine polymérique principale.
Le terme « **monomère** » tel qu'utilisé se rapporte à une molécule qui peut subir une polymérisation.
Le terme « **polymérisation** » tel qu'utilisé se rapporte au procédé de transformation d'un monomère ou d'un mélange de monomères en un polymère d'architecture prédéfinie (bloc, gradient, statistique...).
On entend par « **copolymère** », un polymère regroupant plusieurs unités monomères différentes.
On entend par « **copolymère statistique** », un copolymère dans lequel la distribution des unités monomères le long de la chaîne suit une loi statistique, par exemple un copolymère de type bernoullien (ordre zéro de Markov) ou markovien du premier ou du second ordre. Lorsque les unités de répétition sont réparties au hasard le long de la chaîne, les polymères ont été formés par un processus de Bernoulli et sont appelés copolymères aléatoires. Le terme copolymère aléatoire est souvent utilisé, même lorsque le processus statistique ayant prévalu lors de la synthèse du copolymère n'est pas connu.
On entend par « **copolymère à gradient** », un copolymère dans lequel la distribution des unités monomères varie de manière progressive le long des chaines.
On entend par « **copolymère alterné** », un copolymère comprenant au moins deux entités monomères qui sont distribuées en alternance le long des chaines.
On entend par « **copolymère à blocs** », un polymère comprenant une ou plusieurs séquences ininterrompues de chacune des espèces polymères distincts, les séquences polymères étant chimiquement différentes l'une de, ou des, autre(s) et étant liées entre elles par une liaison chimique (covalente, ionique, liaison hydrogène, ou de coordination). Ces séquences polymères sont encore dénommées blocs polymères. Ces blocs présentent un paramètre de ségrégation de phase (paramètre d'interaction de Flory-Huggins) tel que, si le degré de polymérisation de chaque bloc est supérieur à une valeur critique, ils ne sont pas miscibles entre eux et se séparent en nano-domaines.

Le terme « **miscibilité** » ci-dessus s'entend de la capacité de deux ou plusieurs composés à se mélanger totalement pour former une phase homogène ou « pseudo-homogène », c'est-à-dire sans symétrie cristalline ou quasi-cristalline apparente à courte ou longue distance. On peut déterminer le caractère miscible d'un mélange quand la somme des températures de transition vitreuse (Tg) du mélange est inférieure strictement à la somme des Tg des composés pris isolément.

Dans la description, on parle aussi bien « **d'auto-assemblage** » que « **d'auto-organisation** » ou encore de « **nano-structuration** » pour décrire le phénomène bien connu de séparation de phase des copolymères à blocs, à une température d'assemblage encore dénommée température de recuit.

On entend par surface « **neutre** » ou « **pseudo-neutre** », une surface qui, dans sa globalité, ne présente pas d'affinité préférentielle avec un des blocs d'un copolymère à blocs. Elle permet ainsi une répartition équitable ou « pseudo-équitable » des blocs du copolymère à blocs à la surface. La neutralisation de la surface d'un substrat permet l'obtention d'une telle surface « **neutre** » ou « **pseudo-neutre** ».

On entend par surface « **non neutre** », une surface qui, dans sa globalité présente une affinité préférentielle avec un des blocs d'un copolymère à blocs. Elle permet une orientation des nano-domaines du copolymère à blocs de façon parallèle ou non perpendiculaire.

On définit l'énergie de surface (notée γx) d'un matériau « **x** » donné, comme étant l'énergie excédentaire à la surface du matériau par comparaison à celle du matériau pris en masse. Lorsque le matériau est sous forme liquide, son énergie de surface est équivalente à sa tension superficielle.

Lorsqu'on parle des énergies de surfaces ou plus précisément des tensions interfaciales d'un matériau et d'un bloc d'un copolymère à blocs donnés, celles-ci sont comparées à une température donnée, et plus particulièrement à une température permettant l'auto-organisation du copolymère à blocs.

On entend par « **interface inférieure** » d'un copolymère à blocs, l'interface en contact avec une couche ou un substrat sous-jacent sur laquelle/lequel ledit copolymère à blocs est déposé. On note que cette interface inférieure est neutralisée par une technique classique, c'est-à-dire qu'elle ne présente pas, dans sa globalité, d'affinité préférentielle avec un des blocs du copolymère à blocs.

On entend par « **interface supérieure** » ou « surface supérieure » d'un copolymère à blocs, l'interface en contact avec une couche supérieure, dite top coat notée TC, appliquée à la surface dudit copolymère à blocs. On note que la couche supérieure de top coat TC, peut présenter de préférence à la fois des zones présentant une affinité préférentielle avec l'un des blocs du copolymère à blocs et des zones présentant aucune affinité préférentielle avec l'un des blocs du copolymères à blocs afin que les nano-domaines du copolymère à blocs puissent s'orienter respectivement parallèlement et perpendiculairement aux interfaces au moment du recuit d'assemblage selon les zones situées en regard du copolymère à blocs assemblés.

On entend par « **solvant orthogonal à un (co)polymère** », un solvant non susceptible d'attaquer ou de dissoudre ledit (co)polymère.

On entend par « **polymère liquide** » ou « **polymère visqueux** », un polymère présentant, à une température supérieure à la température de transition vitreuse, de par son état caoutchoutique, une capacité de déformation accrue du fait de la possibilité donnée à ses chaines moléculaires de se mouvoir librement. Les phénomènes hydrodynamiques à l'origine du démouillage apparaissent tant que le matériau n'est pas dans un état solide, c'est-à-dire indéformable du fait de la mobilité négligeable de ses chaines moléculaires.

On entend par « **film discontinu** », un film dont l'épaisseur n'est pas constante du fait du retrait d'une ou plusieurs zones, laissant apparaitre des trous.

Par « **motif** » dans un masque de nano-lithographie, on entend une zone d'un film comprenant une succession de formes alternativement en creux et en saillie, ladite zone présentant une forme géométrique souhaitée, et les formes en creux et en saillies pouvant être des lamelles, des cylindres, des sphères ou des gyroïdes

On entend par « **dimension** » ou « **D** » au sens de l'invention, une longueur, une largeur, une profondeur, une hauteur, une épaisseur, un diamètre.

On entend par dimension « **équivalente** » ou « **identique** » ou « de **même** dimension » au sens de l'invention une variation entre deux valeurs mesurées ou entre une valeur mesurée et une valeur souhaitée de moins de 20 %, de préférence de moins de 10%. Par dimension « **non équivalente** » ou « **différente** » on entend une différence entre une valeur mesurée et une valeur souhaitée ou prédéterminée ou entre deux valeurs mesurées de plus de 10 %, de préférence de plus de 20 %.

Dans la suite de l'invention, on entend par « **couche polymérique réticulée** », une couche composée d'une ou plusieurs couches de matériaux différents, déposée(s) sur la surface supérieure d'un copolymère à blocs, et présentant des zones alternativement neutres et non neutres (affines) vis-à-vis des blocs du copolymère à blocs sous-jacent.

On entend par « **surépaisseur** » au sens de l'invention, un surcroît d'épaisseur de la résine de guidage dans la surface de guidage, l'épaisseur se mesurant de préférence par l'écart entre les deux interfaces de la surface de guidage, la surépaisseur présentant un écart supérieur à l'écart entre les deux interfaces de la surface de guidage.

La demanderesse a développé un nouveau procédé dédié au domaine de l'électronique par auto assemblage dirigé, permettant de créer des dimensions D différentes dans le masque de nano-lithographie indépendamment de la période naturelle du copolymère à blocs sans engendrer de défaut. En outre, le procédé développé par la demanderesse permet de varier à volonté la forme et les dimensions dans le masque de nano-lithographie afin de nanostructurer un substrat présentant des nanostructures de dimension différentes.

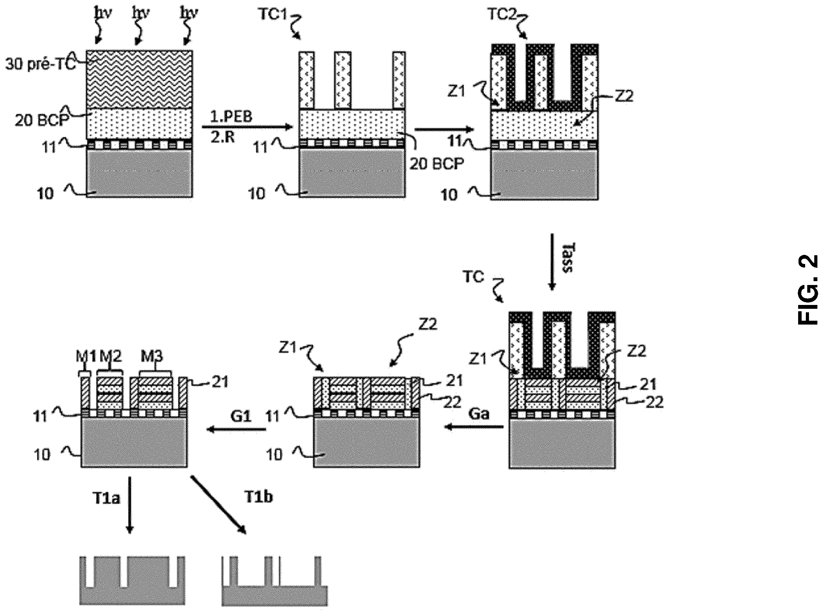

L'invention concerne un procédé tel que schématisé sur les **figures 2, 3 et 4** comprenant la génération d'une surface de guidage 11 au-dessus d'un substrat 10, puis le dépôt d'une couche de copolymère à blocs non assemblés 20 sur la surface de guidage 11. Afin d'éviter tout démouillage du copolymère à blocs non assemblés, le procédé comprend la formation d'une couche polymérique réticulée TC au-dessus de la couche de copolymère à blocs non assemblés. L'empilement ainsi créé subit un recuit thermique à la température d'assemblage Tass du copolymère à blocs non assemblés afin de former un copolymère à blocs nanostructuré sous forme de blocs, les blocs étant nanostructurés sous forme de nanodomaines 21,22 orientés perpendiculairement Z1 en regard des zones neutres de la couche polymérique réticulée TC ou parallèlement Z2 en regard des zones non neutres de la couche polymérique réticulée TC. La couche polymérique réticulée TC est par la suite retirée, de préférence par gravure, ainsi qu'un des blocs nanostructurés de sorte à former des motifs d'un masque de nano-lithographie. Le masque est alors utilisé pour graver le substrat et obtenir un substrat nanostructuré présentant des nanostructures de dimensions différentes.

Pour cela, la surface du substrat peut être neutralisé ou pseudo-neutralisé. Le substrat 10 est de préférence solide et de nature quelconque (oxyde, métal, semi-conducteur, polymère...) selon les applications auxquelles il est destiné. De manière préférée, mais non exhaustive, le matériau constitutif du substrat peut être choisi parmi : le silicium Si, un oxyde de silicium SixOy, le nitrure de silicium Si3N4, un oxynitrure de silicium SixNyOz, un oxyde d'aluminium AlxOy, un nitroxyde de titane TixOyNz, un oxyde d'hafnium HfxOy, des métaux, des couches organiques de type SoC (acronyme anglais de « Spin on Carbon ») ou BARC (acronyme anglais de « bottom anti-reflectant coating ») ou encore des substrats souples en polydiméthylsiloxane PDMS par exemple.

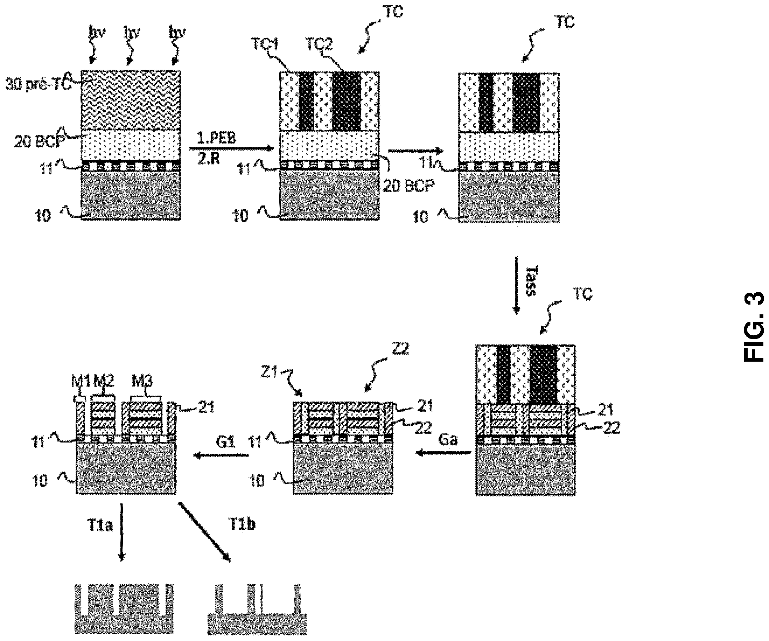

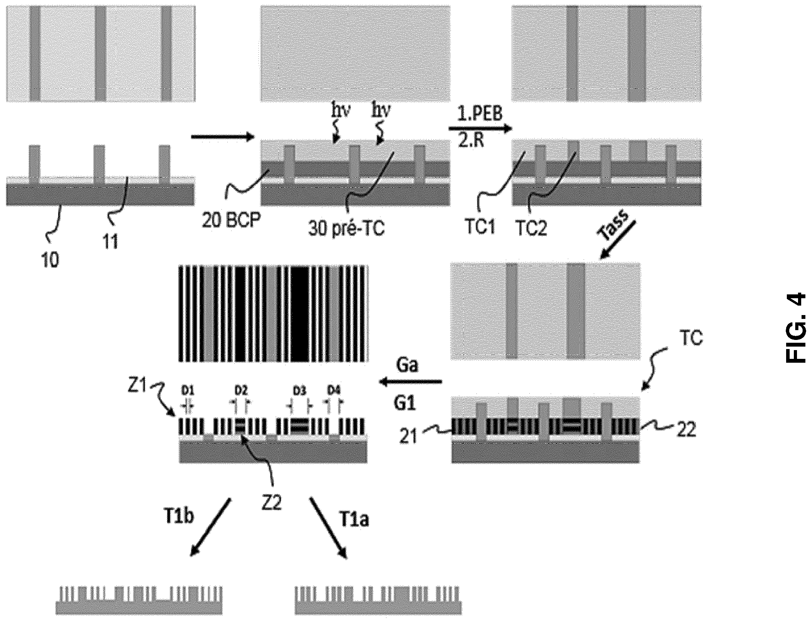

Pour permettre la neutralisation ou la pseudo-neutralisation de sa surface, le substrat 10 comporte ou non des motifs, lesdits motifs étant pré-dessinés par une étape ou un enchainement d'étapes de lithographie de nature quelconque préalablement à l'étape de dépôt de la première couche 20 de copolymère à blocs BCP. Lesdits motifs sont destinés à guider l'organisation dudit copolymère à blocs BCP par la technique dite de chemo-épitaxie, **figures 2 et 3** ou de graph-oépitaxie, **figure 4,** ou encore une combinaison de ces deux techniques, pour obtenir une surface de guidage au-dessus du substrat.

La surface de guidage comporte des zones neutres et des zones non neutres vis-à-vis de la couche de copolymères à blocs non assemblés. En outre, au moins une desdites zones neutres ou non neutres de la surface de guidage présente une première dimension.

Selon un mode de réalisation illustré sur la **figure 4,** la surface de guidage implique la mise en oeuvre d'une technique de grapho-épitaxie à l'aide d'une résine de guidage. Selon ce mode de réalisation, la résine de guidage comporte des surépaisseurs. Les surépaisseurs présentent de préférence, des propriétés de gravure similaires à un des blocs du copolymère à blocs. Par ailleurs, la gravure de la résine de guidage peut être réalisée selon un mode positif ou un mode négatif. En mode négatif T1a, seules les régions exposées de la résine de guidage sont transférées dans le substrat. Inversement, en mode positif T1b seule les régions non exposées de la résine de guidage sont transférées dans le substrat. Autrement dit, en mode négatif, la résine de guidage se comporte lors de la gravure comme le au moins un bloc retiré (gravé) du copolymère à blocs assemblés. Ainsi, la résine de guidage est gravée en même temps que ledit bloc. En mode positif, la résine de guidage se comporte lors de la gravure comme le ou les blocs non retirés (non gravé) du copolymère à blocs assemblés. Ainsi, la résine de guidage résiste à la gravure.

Par ailleurs, la résine de guidage peut être neutre vis-à-vis du copolymère à blocs, ce qui se traduit après l'assemblage du copolymère à blocs, par une orientation perpendiculaire de ses nanodomaines à son interface inférieure.

Toutefois, la résine de guidage peut également être non neutre vis-à-vis du copolymère à blocs, ce qui se traduit après l'assemblage du copolymère à blocs, par une orientation parallèle de ses nanodomaines à son interface inférieure.

Un exemple particulier consiste à greffer une couche d'un copolymère statistique comportant un ratio judicieusement choisi des mêmes monomères que ceux du copolymère à blocs BCP 20 déposé par-dessus. La couche du copolymère statistique permet d'équilibrer l'affinité initiale du substrat pour le copolymère à blocs BCP 20. La réaction de greffage peut être obtenue par un moyen quelconque thermique, photochimique ou encore par oxydo-réduction par exemple.

Cette surface de guidage 11 permet avantageusement de guider le copolymère à blocs, de préférence les nanodomaines du copolymère à blocs, particulièrement lors de l'assemblage de celui-ci afin d'obtenir des zones commensurables.

Ceci permet en outre de réduire les défauts induits lorsque la période du copolymère à blocs est contrainte.

La surface de guidage 11 participe ainsi à la création de motifs de dimensions différentes pour un même copolymère à blocs, notamment les zones non neutres, autorisant des dimensions variables.

Lorsque la surface de guidage 11 a été générée au-dessus du substrat 10, le procédé comprend le dépôt de la couche de copolymère à blocs 20 non assemblé sur la surface de guidage tel qu'illustré sur les **figures 2, 3 et 4.**

En ce qui concerne cette couche de copolymère à blocs non assemblé, le copolymère à blocs BCP comprend « n » blocs, n étant un nombre entier quelconque supérieur ou égal à 2. Le copolymère à blocs BCP est plus particulièrement défini par la formule générale suivante : A-*b*-B-*b*-C-*b*-D-*b*-....-*b*-Z

où A, B, C, D,..., Z, sont autant de blocs « i »... « j » représentant soit des entités chimiques pures, c'est-à-dire que chaque bloc est un ensemble de monomères de natures chimiques identiques, polymérisés ensemble, soit un ensemble de co-monomères copolymérisés ensemble, sous forme, en tout ou partie, de copolymère à blocs ou statistique ou aléatoire ou à gradient ou alterné.

Chacun des blocs « i »... « j » du copolymère à blocs BCP à nano-structurer peut donc potentiellement s'écrire sous la forme : i= $a_i$-*co*-$b_i$-*co*-...-*co*-$z_i$, avec i≠...≠j, en tout ou partie. La fraction volumique de chaque entité $a_i$...$z_i$ peut aller de 1 à 99%, en unités de monomère, dans chacun des blocs i... j du copolymère à blocs BCP.

La fraction volumique de chacun des blocs i...j peut aller de 5 à 95% du copolymère à blocs BCP.

On définit la fraction volumique comme étant le volume d'une entité par rapport à celui d'un bloc, ou le volume d'un bloc par rapport à celui du copolymère à blocs.

La fraction volumique de chaque entité d'un bloc d'un copolymère, ou de chaque bloc d'un copolymère à blocs, est mesurée de la manière décrite ci-après. Au sein d'un copolymère dans lequel au moins l'une des entités, ou l'un des blocs s'il s'agit d'un copolymère à blocs, comporte plusieurs co-monomères, il est possible de mesurer, par RMN du proton, la fraction molaire de chaque monomère dans l'ensemble du copolymère, puis de remonter à la fraction massique en utilisant la masse molaire de chaque unité monomère. Pour obtenir les fractions massiques de chaque entité d'un bloc, ou chaque bloc d'un copolymère, il suffit alors d'additionner les fractions massiques des co-monomères constitutifs de l'entité ou du bloc. La fraction volumique de chaque entité ou bloc peut ensuite être déterminée à partir de la fraction massique de chaque entité ou bloc et de la densité du polymère formant l'entité ou le bloc. Cependant, il n'est pas toujours possible d'obtenir la densité des polymères dont les monomères sont copolymérisés. Dans ce cas, on détermine la fraction volumique d'une entité ou d'un bloc à partir de sa fraction massique et de la densité du composé majoritaire en masse de l'entité ou du bloc.

La masse moléculaire du copolymère à blocs BCP peut aller de 1000 à 500000 g.mol$^{-1}$.

Le copolymère à blocs BCP peut présenter n'importe quel type d'architecture : linéaire, en étoile (tri- ou multi-bras), greffé, dendritique, peigne.

Chacun des blocs i, ... j d'un copolymère à blocs, présente une énergie de surface notée $\gamma_i$... $\gamma_j$, qui lui est propre et qui est fonction de ses constituants chimiques, c'est-à-dire de la nature chimique des monomères ou co-monomères qui le composent. De même, chacun des matériaux constitutifs d'un substrat présentent leur propre valeur d'énergie de surface.

Chacun des blocs i, ... j du copolymère à blocs présente en outre un paramètre d'interaction de type Flory-Huggins, noté : $\chi_{ix}$, lorsqu'il interagit avec un matériau « x » donné, qui peut être un gaz, un liquide, une surface solide, ou une autre phase de polymère par exemple, et une énergie inter-faciale notée « $\gamma_{ix}$ », avec $\gamma_{ix} = \gamma_i - (\gamma_x \cos \theta_{ix})$, où $\theta_{ix}$ est l'angle de contact, non nul, entre les matériaux i et x, avec le matériau x formant une goutte sur le matériau i. Le paramètre d'interaction entre deux blocs i et j du copolymère à blocs est donc noté $\chi_{ij}$.

Il existe une relation liant $\gamma_i$ et le paramètre de solubilité d'Hildebrand $\delta_i$ d'un matériau i donné, tel que décrit dans le document Jia et al., Journal of Macromolecular Science, B, 2011, 50, 1042. De fait, le paramètre d'interaction de Flory Huggins entre deux matériaux donnés i et x est indirectement lié aux énergies de surfaces $\gamma_i$ et $\gamma_x$ propres aux matériaux, on pourra par conséquent soit parler en termes d'énergies de surface, soit en termes de paramètre d'interaction pour décrire le phénomène physique apparaissant à l'interface des matériaux.

Lorsqu'on parle d'énergies de surface d'un matériau et de celles d'un copolymère à blocs BCP donné, on sous-entend que l'on compare les énergies de surface à une température donnée, et cette température est celle (ou fait au moins partie de la plage de températures) permettant l'auto-organisation du BCP.

Cette couche de copolymère à blocs est déposée par une technique classique telle que par exemple par dépôt à la tournette ou « spin coating ». En outre cette couche peut présenter une épaisseur au moins égale à 10 nm.

Le copolymère à blocs est nécessairement déposé dans un état liquide/visqueux, de manière à ce qu'il puisse se nanostructurer à la température d'assemblage, lors d'une étape ultérieure de recuit.

De façon préférentielle, mais non-limitante pour l'invention, le copolymère à bloc utilisé comporte au moins un bloc où un hétéroatome tel que du silicium, du germanium, du titane, du hafnium, du zirconium, de l'aluminium, est présent dans tout ou partie des (co)monomères constitutifs dudit bloc.

De façon préférentielle, mais non limitante pour l'invention, le copolymère à bloc utilisé est dit « high-$\chi$ » (présente un paramètre de Flory-Huggins élevé), c'est-à-dire qu'il doit avoir un paramètre plus important que celui du système dit « PS-*b*-PMMA » à la température d'assemblage considéré, tel que défini par Y. Zhao, E. Sivaniah and T. Hashimoto, Macromolecules, 2008, 41 (24), pp 9948-9951 (Détermination du paramètre de Flory-Huggins entre styrène (« S ») et MMA (« M ») :

$$\chi SM = 0{,}0282 + (4{,}46/T))$$

Le procédé selon l'invention comprend après le dépôt de la couche de copolymère à blocs 20 non assemblés, la formation d'une couche polymérique réticulée TC au-dessus de la couche de copolymère à blocs 20 non assemblé. Cette couche est soumise à une ou des réticulations localisées afin de définir, au sein de la couche de copolymère réticulée, des zones adjacentes alternativement neutres et non neutres vis-à-vis des blocs du copolymère à blocs sous-jacent.

En outre, au moins une desdites zones non neutres de la couche polymérique réticulée présente une deuxième dimension.

Une étape ultérieure de recuit à la température d'assemblage du copolymère à blocs sous-jacent 20 permet alors de nanostructurer le copolymère à blocs et d'obtenir des blocs nanostructurés comprenant des nano-domaines 21, 22 orientés perpendiculairement Z1 aux interfaces situées en regard des zones d'affinité neutre et des blocs nanostructurés comprenant des nanodomaines 21, 22 orientés parallèlement Z2 aux interfaces situées en regard des zones non neutres.

La couche polymérique réticulée ainsi qu'un des blocs du copolymère à blocs en regard des zones neutres de la couche polymérique réticulée, c'est-à-dire les blocs du copolymère à blocs dans lesquels les nano-domaines sont orientés perpendiculairement Z1 aux interfaces, sont ensuite retirés par gravure. Le retrait d'un des blocs du copolymère à blocs étant un retrait de seulement une partie des nanodomaines d'un des blocs du copolymère à blocs nanostructurés, en particulier de seulement les nanodomaines perpendiculaire dudit bloc, de sorte que les nanodomaines parallèles d'au moins deux blocs du copolymère à blocs nanostructuré forment des motifs du masque de nanolithographie. Autrement dit, au moins un des nanodomaines 22 d'un bloc du copolymère à blocs nanostructurés situé en regard des zones neutre de la couche polymérique réticulée, orientés perpendiculairement aux interfaces, est retiré par gravure. Ainsi, selon le procédé, ne sont conservés que des motifs M1, M2, M3, destinés à former les motifs du masque de nanolithographie. Par ailleurs, et de façon tout à fait avantageuse, les motifs M1, M2 et M3 ne présentent pas la même dimension.

Les différentes étapes de gravure sont de préférence réalisées par gravure plasma. Elles peuvent en outre être réalisées de manière successive, dans un même bâti de gravure, par gravure plasma en ajustant la chimie des gaz en fonction des constituants de chacune des couches à retirer. La chimie des gaz constitutifs du plasma devra par exemple être ajustée en fonction des matériaux à retirer afin de ne pas présenter une sélectivité particulière pour un bloc du copolymère à blocs BCP.

Ainsi, en créant des motifs dans la couche polymérique réticulée qui ne sont pas en commensurabilité avec les zones neutres ou non neutres de la surface de guidage 11, le procédé permet après nanostructuration de la couche de copolymère à blocs non assemblé de créer des zones de dimensions différentes et utilisables afin de nanostructurer un substrat présentant des nanostructures (motifs) de dimensions différentes.

Selon l'invention, **un premier mode de réalisation** tel qu'illustré à **la figure 2,** peut être mis en oeuvre pour la formation d'une couche polymérique réticulée au-dessus de la couche de copolymères à blocs non assemblés.

Pour cela, suite à l'étape de dépôt du film de copolymère à blocs 20, une première couche pré-polymérique, notée pré-TC 30 sur la figure 2, est déposée sur la surface du copolymère à blocs BCP 20. Cette couche pré-polymérique est déposée sur le copolymère à blocs 20 par une technique de dépôt classique, par exemple par dépôt à la tournette ou « spin coating », et se présente dans un état liquide/visqueux.

Cette couche de composition prépolymère comprend un ou plusieurs monomère(s) et/ou dimère(s) et/ou oligomère(s) et/ou polymère(s) en solution.

De préférence, la composition pré-polymère est formulée dans un solvant orthogonal à la couche 20 de copolymère à blocs déjà présente sur le substrat, et comprend au moins :

- une entité chimique monomère, dimère, oligomère ou polymère, ou un mélange quelconque de ces différentes entités, de nature chimique en tout ou partie identique, et au moins un groupement fonctionnel réticulable capable d'assurer la propagation de la réaction de réticulation sous l'effet d'un stimulus ; et
- une ou plusieurs entités chimiques, encore dénommés agents de réticulation, capables d'amorcer la réaction de réticulation sous l'effet du stimulus, tel qu'un générateur de radicaux, un acide et/ou une base.

Le solvant de la couche de prépolymère est choisi de façon à être entièrement « orthogonal » au système polymérique de la couche sous-jacente afin d'éviter une possible re-dissolution de ce polymère dans le solvant de la couche pré-polymère lors de l'étape de dépôt (par spin-coating par exemple). Les solvants de chaque couche respective seront donc très dépendants de la nature chimique du matériau polymère déjà déposé sur le substrat. Ainsi, si le polymère déjà déposé est peu polaire/protique, son solvant étant sélectionné parmi les solvants peu polaires et/ou peu protiques, la couche pré-polymère pourra donc être solubilisée et déposée sur la première couche polymère à partir de solvants plutôt polaires et/ou protiques. Inversement, si le polymère déjà déposé est plutôt polaire/protique, les solvants de la couche pré-polymère pourront être choisis parmi les solvants peu polaires et/ou peu protiques.

La composition pré-polymère peut, dans une variante de réalisation, être utilisée sans solvant. La couche prépolymère est alors soumise à une première stimulation localisée sur des premières zones, référencées TC1 sur la figure 2, ladite stimulation étant choisie parmi un rayonnement lumineux, un bombardement ionique, une stimulation thermique, un plasma ou un processus électrochimique. Cette stimulation provoque alors une réaction de réticulation des chaines moléculaires du pré-polymère par action d'un premier agent de réticulation dans lesdites premières zones TC1 soumises à ladite stimulation. Les premières zones réticulées obtenues présentent alors une première affinité vis-à-vis des blocs du copolymère à blocs. De façon préférée, le stimulus est de nature électrochimique et appliqué via un faisceau d'électrons ou un rayonnement lumineux, et de façon encore plus préférée, c'est un rayonnement lumineux.

Dans un mode de réalisation particulièrement avantageux, la réaction de réticulation des composants de la couche de pré-polymère pré-TC est activée par l'exposition de la couche à un rayonnement lumineux, tel qu'un rayonnement dans des gammes de longueur d'onde allant de l'ultraviolet à l'infrarouge. De préférence, la longueur d'onde d'illumination est comprise entre 10 nm et 1500 nm et de manière davantage préférée, elle est comprise entre 100 nm et 500 nm. Dans un mode de réalisation particulier la source lumineuse permettant d'exposer la couche au rayonnement lumineux peut être un dispositif laser. Dans un tel cas, la longueur d'onde du laser sera de préférence centrée sur une des longueurs d'onde suivantes : 436 nm, 405 nm, 365 nm, 248 nm, 193 nm, 172 nm, 157 nm ou 126 nm. Une telle réaction de réticulation présente l'avantage de s'opérer à température ambiante ou modérée, de préférence inférieure ou égale à 150°C et de manière davantage préférée, inférieure ou égale à 110°C. Elle est en outre très rapide, de l'ordre de quelques secondes à quelques minutes, de préférence inférieure à 2 minutes. De préférence, les composés constitutifs de la couche de pré-polymère, avant réticulation, sont stables en solution tant qu'ils sont protégés de l'exposition à la source lumineuse. Ils sont donc stockés dans des contenants opaques. Lorsqu'une telle couche de pré-polymère est déposée sur la couche sous-jacente, les constituants, stables en solution, sont soumis au rayonnement lumineux permettant la réticulation de la couche dans une durée très rapide (typiquement inférieure à 2 minutes). Ainsi, la couche pré-polymérique, dans les zones TC1 soumises au rayonnement, n'a pas le temps de démouiller. De plus, au fur et à mesure que la réaction se propage, dans les zones exposées, la taille des chaines croit ce qui limite les problèmes de solubilisation et d'inter-diffusion à l'interface lorsque cette dernière est dans une configuration « liquide / liquide ».

La réaction de réticulation, par irradiation de la couche pré-polymère, peut se faire à une température modérée, bien inférieure à la température de transition vitreuse de la couche copolymère 20 sous-jacente, afin de favoriser la diffusion des espèces réactives et ainsi augmenter la rigidité du réseau réticulé.

Selon une variante de l'invention, l'irradiation lumineuse de la couche pré-polymère est effectuée directement sur un empilement porté à température désirée, de préférence inférieure à 110°C, pour optimiser le temps total de réaction.

Cette étape de photo-réticulation peut être réalisée à travers un masque de lithographie. Dans une variante de réalisation, il est également possible d'utiliser une source lumineuse locale, de type laser par exemple, pour réaliser l'irradiation locale de la couche de prépolymère, sans avoir recourt à un masque de lithographie.

De préférence, une étape de rinçage de la couche polymérique localement réticulée TC1 est réalisé de façon à éliminer les zones non réticulées et former des zones évidées dans la couche polymérique localement réticulée TC1. Pour cela, l'empilement de couches est rincé, étape notée « R » sur la Figure 2, dans un solvant orthogonal au copolymère à blocs BCP. La couche polymérique localement réticulée peut ensuite être soumise à **un recuit post-exposition** (noté par son acronyme anglosaxon PEB « Post Exposure Bake »), à une température inférieure à la température d'assemblage du copolymère à blocs. Ce recuit permet alors la diffusion d'acides ou de bases libérés lors de l'exposition. Typiquement, le PEB de la couche polymérique localement réticulée est réalisé à une température de l'ordre de 90°C pendant une durée de l'ordre de 3 minutes. Cette couche peut optionnellement comprendre un agent de réticulation latent thermique, de type triflate d'ammonium par exemple.

Suite au rinçage et au recuit de la couche polymérique localement réticulée, le procédé peut comprendre **le dépôt d'une deuxième couche pré-polymérique TC2**. Cette couche est alors déposée d'une part, sur les zones préalablement réticulées de la couche polymérique localement réticulée TC1 et d'autre part, sur la surface du copolymère à blocs non recouverte par la couche polymérique localement réticulée et correspondant aux zones évidées de la couche polymérique localement réticulée TC1.

Cette deuxième couche d'une composition pré-polymérique TC2, qui peut être neutre, ou non, vis-à-vis du copolymère à blocs sous-jacent, (mais d'affinité opposée à la couche polymérique localement réticulée TC1) est ensuite réticulée, par exemple par irradiation lumineuse, par un processus électrochimique, un plasma, un bombardement ionique ou une espèce chimique, afin d'éviter l'apparition d'un phénomène de démouillage du copolymère à blocs 20 au moment de sa nano-structuration, lors de l'étape suivante de recuit à la température d'assemblage Tass du copolymère à blocs. Une réticulation de la deuxième couche pré-polymérique TC2 est initiée de manière à obtenir des zones réticulées présentant une deuxième affinité vis-à-vis des blocs du copolymère à blocs, la deuxième affinité étant opposée à la première affinité.

Ainsi, et tel qu'illustré sur l'exemple de la figure 2, la première couche polymérique localement réticulée TC1 ne présente pas par exemple une affinité privilégiée pour un des blocs du copolymère à blocs 20 sous-jacent de sorte qu'au moment de l'assemblage du copolymère à blocs, les nano-domaines situés sous les premières zones TC1 réticulées vont s'orienter perpendiculairement Z1 aux interfaces ; tandis que la deuxième couche réticulée TC2 présente une affinité non neutre vis-à-vis d'un des blocs du copolymère à blocs sous-jacent, de sorte qu'au moment de l'assemblage du copolymère à blocs, les nano-domaines situés sous les deuxième zones TC2 réticulées vont s'orienter parallèlement Z2 aux interfaces.

Ces deux couches réticulées TC1 et TC2 permettent de générer une couche polymérique réticulée TC présentant des zones réticulées adjacentes, d'affinité opposée vis-à-vis du copolymère à blocs sous-jacent et de dimension non équivalentes. De préférence, la couche polymérique réticulée TC présente au moins une zone non neutre de dimension différente à la zone neutre. Alternativement, la couche polymérique réticulée peut présenter au moins deux zones non neutres de dimensions différentes.

De manière générale, les différentes étapes de dépôt des couches successives peuvent être réalisées par toute méthode connue de la microélectronique choisie parmi : le dépôt par doctor blade, le dépôt par Langmuir-Blodgett, le dépôt chimique en phase vapeur, le dépôt physique en phase vapeur, le dépôt de couches minces atomiques, ou le dépôt par spin-coating. De préférence, mais de façon non-limitative, les dépôts sont réalisés par la technique de spin-coating.

Suite à l'obtention de la couche polymérique réticulée, comprenant des zones réticulées alternativement neutres et non neutres vis-à-vis du copolymère à blocs sous-jacent, la solubilisation de la couche polymérique réticulée dans la couche 20 de copolymère à blocs BCP sous-jacente est fortement limitée voire évitée et l'apparition d'un phénomène de démouillage est retardée voire évitée.

Selon un mode de réalisation alternatif, lorsque deux couches pré polymériques forment la couche polymérique réticulée, il est possible de ne structurer que l'une ou l'autre des couches pré polymériques. Ainsi, dans le cas deux couches pré-polymériques d'affinité opposées, une première couche pré-polymérique d'une première affinité peut être réticulée, puis subir un recuit. Les zones non réticulées de ladite couche pré-polymérique sont alors rincées afin de former des zones du copolymère à blocs sous-jacent non recouvertes par la première couche pré-polymérique réticulée. Une deuxième couche pré-polymérique d'affinité opposée à la première couche est déposée afin de recouvrir les zones du copolymère à blocs non recouvertes. Un recuit est alors réalisé et le copolymère à blocs est assemblé.

De la sorte, pour une même série de motifs, différents masques de lithographie peuvent être utilisés selon l'affinité de la couche pré-polymérique initialement exposée.

**L'étape suivante consiste à soumettre l'empilement obtenu à un recuit thermique, à une température d'assemblage du copolymère à blocs,** de manière à permettre l'auto-assemblage du copolymère à blocs en nano-domaines 21, 22.

La température d'assemblage dépend du copolymère à blocs utilisé. En général, elle est supérieure à 100°C, et de façon encore préférée, elle est supérieure à 200°C, tout en étant inférieure à une éventuelle température de dégradation dudit copolymère à blocs. De préférence, la température d'assemblage Tass du copolymère à blocs est inférieure à la température de transition vitreuse Tg de la couche polymérique sous sa forme réticulée et lithographiée ou tout au moins inférieure à une température à laquelle le(s) matériau(x) de la couche polymérique se comportent comme un fluide viscoélastique. Cette température se trouve alors dans une zone de températures, correspondant à ce comportement viscoélastique, située au-dessus de la température de transition vitreuse Tg du matériau de la couche polymérique. Le recuit thermique est réalisé pendant une durée déterminée, de préférence inférieure à 60 minutes et de manière davantage préférée inférieure à 5 minutes, afin de provoquer la nano-structuration du copolymère à blocs. Les nano-domaines 21, 22 situés sous les zones neutres réticulées TC1 vis-à-vis du copolymère à blocs s'orientent alors perpendiculairement Z1 à l'interface avec la couche polymérique réticulée, et les nano-domaines 21, 22 situés sous les zones non neutres réticulées TC2 s'orientent parallèlement Z2 à l'interface avec la couche polymérique réticulée.

Ainsi, il est possible grâce au procédé de réaliser des zones neutres et des zones non neutres de dimensions équivalentes ou non équivalentes entre elles. Il est également possible de réaliser plusieurs zones non neutres, chacune desdites zones non neutres étant également de dimensions équivalentes ou non équivalentes entre elles et de préférences de dimensions non équivalentes entre elles. On entend par non équivalente au sens de l'invention des dimensions différentes. Ainsi, chaque zone neutre ou non neutre peut présenter une dimension qui lui est propre telle qu'une longueur, une profondeur ou hauteur, ou encore largeur. De préférence, la couche polymérique réticulée TC présente au moins une zone non neutre de dimensions différente de celles de la zone neutre. Alternativement, la couche polymérique réticulée peut présenter au moins deux zones non neutres de dimensions différentes.

Dans le mode de réalisation illustré sur la figure 2, les zones sélectionnées du copolymère à blocs pour former les motifs M1, M2, M3 destinés à nanostructurer le substrat, sont les zones situées sous les zones TC1 et sous les zones TC2 de la couche polymérique réticulée.

Dans l'exemple illustré sur la figure 2, la première couche de la couche polymérique réticulée ne présente pas une affinité préférentielle vis-à-vis d'un des blocs du copolymère à blocs sous-jacent, si bien que dans les zones du copolymère BCP recouvertes par cette couche, les nano-domaines 21, 22 s'orientent spontanément perpendiculairement Z1 aux interfaces. La deuxième couche de la couche polymérique réticulée, d'affinité opposée à la première couche, présente une affinité non neutre vis-à-vis d'un des blocs du copolymère à blocs sous-jacent, si bien que dans les zones du copolymère BCP recouvertes par cette couche, les nano-domaines 21, 22 s'orientent spontanément parallèlement Z2 aux interfaces. Dans ce cas, lors de l'étape de recuit à la température Tass d'autoassemblage, les nano-domaines 21, 22 situés sous la première couche de la couche polymérique réticulée du copolymère à blocs s'orientent de façon perpendiculaire Z1 aux interfaces, tandis que les nano-domaines 21, 22 situés sous la deuxième couche de la couche polymérique réticulée, s'orientent parallèlement Z2 aux interfaces.

Préalablement à l'étape de gravure G1 de l'empilement, une étape de gravure préalable Ga est réalisée, de préférence par plasma, pour retirer la couche polymérique réticulée, de manière à découvrir les nano-domaines 21, 22 du copolymère à blocs nano-structuré orientés perpendiculairement Z1 ou parallèlement Z2. Une manière de retirer la couche polymérique réticulée consiste à utiliser la gravure sèche, tel que par plasma par exemple avec une chimie de gaz appropriée, telle qu'une base d'oxygène majoritaire dans un mélange avec un gaz plutôt inerte tel que He, Ar, par exemple. Une telle gravure sèche est d'autant plus avantageuse et aisée à réaliser si le copolymère à blocs BCP 20 sous-jacent contient par exemple du silicium dans un de ses blocs, qui agit alors comme une couche d'arrêt de gravure.

L'étape de gravure G1 de l'empilement est ensuite réalisé ; au moins un des nano-domaines 22 orientés perpendiculairement aux interfaces peut être retiré, de manière à former un motif M1. Dans ce cas, les nano-domaines 21 restants pour former le motif M1 doivent pouvoir résister à la gravure. Pour cela, les blocs correspondant aux nano-domaines 21 et destinés à être conservés pour former le motif M1, peuvent par exemple contenir du silicium qui agit alors comme une couche d'arrêt de gravure.

De façon alternative, l'au moins un des nano-domaines 21 orientés perpendiculairement aux interfaces peut être retiré de manière à former un motif M1. Dans ce cas, les nano-domaines 22 restants pour former le motif M1 doivent pouvoir résister à la gravure. Pour cela, les blocs correspondant aux nano-domaines 22 et destinés à être conservés pour former le motif M1, peuvent par exemple contenir du silicium qui agit alors comme une couche d'arrêt de gravure.

En outre, les zones Z2 sont conservées et sont également destinées à former des motifs M2, M3 transférés dans le substrat sous-jacent par gravure. Les propriétés de transfert de ces zones peuvent être différentes, la zone Z1 ne comprenant alors plus qu'un seul type de nano-domaine perpendiculaire alors que la zone Z2 comprenant les nanodomaines 21 et 22 orientés parallèlement. Cet inconvénient est néanmoins tout à fait mineur et peut être facilement contourné en augmentant l'épaisseur du film de BCP, pour compenser la possible différence de profondeur transférée par rapport à un motif de la zone Z1. Par ailleurs, la gravure de la surface de guidage et plus particulièrement de la résine de guidage peut être réalisée en mode positif ou bien en mode négatif.

On obtient alors un film discontinu de copolymère à blocs dans lequel une pluralité de motifs M1, M2, M3 sont créés et séparés les uns des autres, tout en présentant des dimensions différentes. En outre les zones du copolymère à blocs situées sous les zones neutres de la couche polymérique réticulée présentent des nanodomaines orientés perpendiculairement aux interfaces et la dimension des nanodomaines correspond à la première dimension des zones neutres.

De façon alternative, les zones du copolymère à blocs situées sous les zones non neutres de la couche polymérique réticulée, présentent des nanodomaines orientés parallèlement aux interfaces, et la dimension des nanodomaines correspond à la première dimension des zones non neutres.

Une fois les motifs M1, M2, M3 obtenus, on obtient alors un film discontinu et poreux, formant un masque de nano-lithographie et comportant une pluralité de motifs M1, M2, M3 etc..., séparés les uns des autres, et destinés à être transférés dans le substrat 10 sous-jacent.

De préférence cette étape de transfert peut être réalisée par gravure plasma, dans le même bâti de gravure sèche, simultanément ou successivement à l'étape de gravure G1 de retrait du au moins un nano-domaine 22 ou 21. Le bâti peut être un réacteur ICP (Inductively Coupled Plasmas) ou un réacteur CCP (Capacitively Coupled Plasma) par exemple.

Ainsi, des empilements successifs de matériaux de constitution atomique particulière permettent de transférer très sélectivement le motif dans les différentes couches par gravure plasma avec des chimies de gaz bien distinctes, permettant de graver un substrat en profondeur. Le substrat par exemple silicium peut être gravé par plasma selon une chimie halogénée ($SF_6$, $CH_3F$, $CH_2F_2$, $CHF_3$, $CF_4$, HBr, $Cl_2$). Les motifs sont alors transférés dans le substrat qui est gravé T1 a et T1b.

A titre d'exemple, dans le cas où le copolymère à blocs contient un hétéroatome tel que du silicium dans un de ses blocs et que la couche polymérique réticulée est entièrement organique ou halogéno-organique, une chimie de gaz du plasma pour les étapes de gravure, peut être un mélange oxygéno-fluoré tel que choisi parmi $O_2/CF_4$, $O_2/CHF_3$, $O_2/CH_2F_2$, $O_2/CH_3F$, $O_2/SF_6$, $HBr/O_2$

ou HBr/Cl$_2$/O$_2$ auquel un gaz diluant tel que He ou Ar peut être ajouté.

Les motifs M1, M2, M3 ainsi créés présentent des dimensions équivalentes ou non équivalentes, de préférence les motifs M2, M3 présentent des dimensions non équivalentes. Les motifs M1, M2, M3 sont destinés à être transféré par gravure(s) dans l'épaisseur du substrat sous-jacent, chaque motif correspondant à une nanostructure destinée à nanostructurer le substrat.

Ainsi, les zones non neutres peuvent être utilisées comme une nouvelle résine de lithographie et apporter de nouvelles dimensions pour nanostructurer le substrat sous-jacent.

Le procédé selon l'invention permet de créer des motifs, selon la couche polymérique réticulée utilisée (neutre ou non neutre) ainsi que grâce à ses différentes réticulations, dans la couche de copolymère à blocs non assemblés qui ne sont pas en commensurabilité avec les motifs de la couche de guidage. Ainsi, après assemblage du BCP, des blocs de dimensions différentes selon les zones Z1 ou Z2 sont utilisables pour nanostructurer le substrat présentant des nanostructures de dimensions différentes.

**Un deuxième mode de réalisation** est illustré **aux figures 3 et 4.**

Dans ce mode de réalisation, la couche polymérique réticulée est formée à partir d'une composition prépolymérique comprenant d'une part, une pluralité de monomères fonctionnels et au moins un groupement fonctionnel réticulable au sein de sa chaine polymérique et d'autre part, deux agents de réticulation chimiquement différents, chaque agent étant apte à initier la réticulation dudit prépolymère en réponse à une stimulation qui lui est propre.

Avantageusement, cela permet de structurer la couche polymérique réticulée. De plus, une telle couche permet de réduire le nombre d'étape du procédé et permet également une simplification du procédé. En effet, une seule couche de composition prépolymère est déposée et l'étape ultérieure de réticulation est optimisée par la présence de chaque agent apte à initier la réticulation. Ainsi, il n'est plus nécessaire de déposer une première couche puis de réticuler ladite première couche pour ensuite re-déposer une deuxième couche devant également subir une réticulation. Ceci se traduit également par un gain de temps.

Selon ce mode de réalisation, deux réticulations successives sont opérées dans des zones primaires TC1 et secondaires TC2 de ladite couche de prépolymère, par stimulation successive des deux agents de réticulation, afin de provoquer une réaction de réticulation des chaines moléculaires dudit prépolymère par action successive du premier agent de réticulation dans lesdites zones primaires TC1 soumises à ladite première stimulation puis du deuxième agent de réticulation dans lesdites zones secondaires TC2 soumises à ladite deuxième stimulation, afin d'obtenir une couche polymérique réticulée, dans laquelle les différentes zones réticulées adjacentes présentent une affinité opposée les unes par rapport aux autres, vis-à-vis des nanodomaines 21, 22 des blocs du copolymère à blocs sous-jacent.

Les première et deuxième stimulations successives, permettant la réticulation de zones primaires TC1 et de zones secondaires TC2 au sein de la couche polymérique, peuvent être choisies parmi : un rayonnement lumineux, un bombardement ionique, une stimulation thermique, un plasma ou un processus électrochimique.

Les deux stimulations peuvent être de natures différentes ou identiques. Toutefois, si elles sont de même nature, l'activation sélective de chaque agent de réticulation se fait par sélection d'un paramétrage de stimulation différent. Ainsi, par exemple, si les deux stimulations successives se font par rayonnement ultraviolet (UV), alors la longueur d'onde d'activation de chaque agent de réticulation est différente. De même, si les deux stimulations successives se font par voie thermique, alors la température d'activation de chaque agent de réticulation est différente.

Lorsque la stimulation se fait par rayonnement lumineux, celle-ci est en général réalisée à travers un masque de photolithographie. Toutefois, l'utilisation d'un dispositif laser, par exemple, permet d'irradier localement et précisément certaines zones sans avoir recours à un masque. De même, il est possible de stimuler thermiquement et localement certaines zones au moyen d'un dispositif laser infra-rouge ou via un moyen mécanique tel qu'une pointe chauffante d'un microscope à force atomique. Selon le moyen utilisé pour réaliser les stimulations successives, chaque stimulation peut donc être réalisée à travers un masque ou non.

En outre, le premier agent de réticulation peut initier la réticulation par réaction avec un premier groupement fonctionnel réticulable de la chaine polymérique tandis que le deuxième agent de réticulation initie la réticulation par réaction avec un groupement fonctionnel réticulable identique ou différent du premier.

De plus, un des deux agents de réticulation peut également réagir avec au moins un groupement fonctionnel de la chaine polymérique du prépolymère.

Par ailleurs, l'un et/ou l'autre des agents de réticulation peut (peuvent) être porté(s) par la chaîne polymérique dudit prépolymère.

De préférence chaque agent de réticulation est présent, dans la composition prépolymère, avec une teneur inférieure ou égale à 30% de la masse totale de ladite composition prépolymère.

Avantageusement, après l'étape de double réticulation, la couche polymérique réticulée obtenue comprend des zones réticulées neutres TC1 et des zones réticulées TC2 non neutres, de dimensions équivalentes ou non entre elles. De préférence, les zones réticulées non neutres présentent des dimensions différentes entre elles.

De plus, une même zone neutre réticulée est destinée à permettre la formation, dans une zone sous-jacente du copolymère à blocs, de nano-domaines orientés perpendiculairement Z1. Après retrait d'un ou plusieurs nano-domaines orientés perpendiculairement et d'un des blocs du copolymères à blocs assemblés, le motif M1, M2, M3 obtenu est apte à être transféré dans un substrat sous-jacent par gravure. En outre, les zones non neutres TC2 sont également destinées à permettre la formation, dans une zone sous-jacente du copolymère à blocs, des nanodomaines orientés parallèlement Z2. Le motif obtenu M2, M3 par ces blocs de nanodomaines orientés parallèlement après retrait de la couche polymérique réticulée est également apte à être transféré dans le substrat sous-jacent par gravure.

Ainsi, grâce à l'invention, les nanodomaines orientés parallèlement participent à la création de motifs dans le substrat. En outre, les motifs crées présentent des périodes différentes tout en présentant un minimum de défaut. Ainsi, grâce à la surface de guidage et à la couche polymérique réticulée, il devient possible de créer des dimensions différentes dans le BCP, indépendamment de sa période naturelle. Un des intérêts majeurs de l'invention est donc d'utiliser les zones non neutres créées dans le BCP (nanodomaines orientés parallèlement) comme une résine de lithographie à part entière, puis de transférer ces motifs dans le substrat en même temps. Ces zones non-neutres font donc partie intégrante du motif final. En outre, il est donc possible de varier à volonté les motifs crées dans le BCP, tout en multipliant les différentes dimensions pour un même motif.

Le choix du retrait d'un ou plusieurs nano-domaines 21, 22 orientés perpendiculairement Z2 afin d'obtenir un ou plusieurs motifs dépend du type de structure que l'on veut obtenir en fin de procédé.

Que cela soit le premier ou le deuxième mode de réalisation, la couche polymérique réticulée comporte de préférence, des zones neutres et des zones non neutres vis-à-vis de la couche de copolymère à blocs non assemblés sous-jacente. La couche polymérique réticulée présente de préférence au moins une zone non neutre de dimension différente des dimensions des zones neutres.

En outre, au moins une des zones non neutres de la couche polymérique réticulée présente une deuxième dimension. De façon préférée, la première et la deuxième dimensions sont différentes de façon à générer dans le masque de nanolithographie des motifs de dimensions différentes et des nanostructures dans le substrat de dimensions différentes après gravure.

**Revendications**

1. Procédé de nano-structuration d'un substrat (10) pour la préparation d'un substrat nanostructuré présentant des nanostructures de dimensions différentes, ledit procédé comprenant les étapes suivantes :

- Génération d'une surface (11) de guidage au-dessus d'un substrat (10) ;
- Dépôt d'une couche (20) de copolymère à blocs non assemblé sur la surface de guidage (11), ladite couche (20) de copolymère à blocs non assemblé étant apte à former, après assemblage, un copolymère à blocs nanostructuré sous forme de nanodomaines (21, 22) ;
- Formation d'une couche polymérique réticulée (TC) au-dessus de la couche (20) de copolymère à blocs non assemblé ; la formation d'une couche polymérique réticulée (TC) au-dessus de la couche (20) de copolymère à blocs non assemblé comporte les sous-étapes suivantes :

- Dépôt d'une première couche d'une composition pré-polymère (pré-TC) sur la couche (20) de copolymère à blocs non assemblé ;
- Réaction de réticulation locale des chaines moléculaires au sein de ladite première couche de composition pré-polymère de façon à générer une couche polymérique localement réticulée (TC1) ;
- Rinçage de la couche polymérique localement réticulée (TC1) afin de retirer les zones non réticulées ;
- Dépôt d'une deuxième couche d'une composition pré-polymère (TC2) au moins sur la couche (20) de copolymère à blocs non assemblé ;
- Réaction de réticulation locale des chaines moléculaires au sein de ladite deuxième couche d'une composition pré-polymère (TC2) de façon à générer une couche polymérique réticulée (TC),
- ou
- la formation d'une couche polymérique réticulée (TC) au-dessus de la couche (20) de copolymère à blocs non assemblé comporte les sous-étapes suivantes :

- déposer une couche de composition prépolymère comprenant d'une part, une pluralité de monomères fonctionnels et au moins un groupement fonctionnel réticulable au sein de sa chaine polymérique et d'autre part, deux agents de réticulation chimiquement différents, chaque agent étant apte à initier la réticulation dudit prépolymère en réponse à une stimulation qui lui est propre, et
- opérer deux réticulations successives dans des zones primaires (TC1) et secondaires (TC2) de ladite couche, par stimulation successive des deux agents de réticulation, afin de provoquer une réaction de réticulation des chaines moléculaires dudit prépolymère par action successive du premier agent de réticulation dans lesdites zones primaires soumises à ladite première stimulation puis du deuxième agent de réticulation dans lesdites zones secondaires soumises à ladite deuxième stimulation afin d'obtenir une couche polymérique réticulée dans laquelle les différentes zones réticulées primaires (TC1) et secondaires (TC2) présentent une affinité opposée vis-à-vis des blocs du copolymère à blocs sous-jacent,

- Recuit à une température correspondant à la température d'assemblage (Tass) de la couche (20) de copolymère à blocs non assemblé ;
- Retrait de la couche polymérique réticulée (TC) et d'un des blocs du copolymère à blocs nanostructuré de sorte à former des motifs d'un masque de nano-lithographie ;
- Gravure du substrat (10) au moyen dudit masque de nano-lithographie ledit procédé étant **caractérisé en ce que** :

    - ladite surface (11) de guidage comporte des zones neutres et des zones non neutres vis-à-vis de la couche (20) de copolymère à blocs non assemblé, au moins une desdites zones neutres ou non neutres de la surface de guidage présentant une première dimension ;
    - ladite couche polymérique réticulée (TC) comporte des zones neutres (TC1) et des zones non neutres (TC2) vis-à-vis de la couche (20) de copolymère à blocs non assemblé, au moins une desdites zones non neutres (TC2) de la couche polymérique réticulée (TC) présentant une deuxième dimension ;
    - ledit retrait d'un des blocs étant un retrait de seulement une partie des nanodomaines (21, 22) d'un des blocs du copolymère à blocs nanostructuré, en particulier de seulement les nanodomaines perpendiculaires (Z1) dudit bloc, de sorte que les nanodomaines parallèles (21, 22) d'au moins deux blocs du copolymère à blocs nanostructuré forment des motifs du masque de nano-lithographie ; et
- lesdites première et deuxième dimensions sont différentes de façon à générer dans le masque de nano-lithographie des motifs (M1, M2, M3) de dimensions différentes et des nanostructures dans le substrat nanostructuré de dimensions différentes après la gravure.

2. Procédé selon la revendication 1 **caractérisé en ce que** la couche (20) de copolymère à bloc non réticulée présente une épaisseur au moins égale à 10 nm.

3. Procédé selon la revendication 1 ou 2 **caractérisé en ce que** la couche polymérique réticulée (TC) présente au moins une zone non neutre de dimension différente à celle de la zone neutre.

4. Procédé selon l'une des revendications précédentes **caractérisé en ce que** la génération d'une surface de guidage (11) au-dessus d'un substrat (10) implique la mise en oeuvre d'une chimie-épitaxie ou d'une grapho-épitaxie.

5. Procédé selon la revendication 4 **caractérisé en ce que** la surface de guidage (11) comporte des surépaisseurs de résine de guidage et **en ce que** les surépaisseurs présentent des propriétés de gravure similaires à un des blocs du copolymère à bloc.

6. Procédé selon la revendication 5 **caractérisé en ce que** la résine de guidage formant les surépaisseurs est non neutre vis-à-vis du copolymère à bloc (20).

7. Procédé selon la revendication 5 **caractérisé en ce que** la résine de guidage formant les surépaisseurs est neutre vis-à-vis du copolymère à bloc (20).

8. Procédé selon l'une des revendications 5 à 7 **caractérisé en ce que** la gravure de la résine de guidage est réalisée selon un mode positif.

9. Procédé selon l'une des revendications 5 à 7, **caractérisé en ce que** la gravure de la résine de guidage est réalisée selon un mode négatif.

10. Procédé selon la revendication 1 **caractérisé en ce que** les zones du copolymère à blocs situées sous les zones neutres de la couche polymérique réticulée, présentent des nanodomaines orientés perpendiculairement aux interfaces et la dimension des nanodomaines correspond à la première dimension des zones non neutres.

11. Procédé selon la revendication 1 **caractérisé en ce que** les zones du copolymère à blocs situées sous les zones non neutres de la couche polymérique réticulée, présentent des nanodomaines orientés parallèlement aux interfaces, et la dimension des nanodomaines correspond à la première dimension des zones non neutres.

**12.** Procédé selon l'une des quelconque des revendications 1 à 11, **caractérisé en ce que** le copolymère à bloc comporte au moins un bloc où un hétéroatome tel que du silicium, du germanium, du titane, du hafnium, du zirconium, de l'aluminium dans tout ou partie des (co)monomères constitutifs dudit bloc.

**13.** Procédé selon l'une des quelconque des revendications 1 à 12, **caractérisé en ce que** la couche polymérique réticulée (TC) présente au moins deux zones non neutres de dimensions différentes.

## Patentansprüche

**1.** Verfahren zum Nanostrukturieren eines Substrats (10) für die Herstellung eines nanostrukturierten Substrats, das Nanostrukturen mit unterschiedlichen Abmessungen aufweist, wobei das Verfahren die folgenden Schritte umfasst:

- Erzeugen einer Führungsoberfläche (11) über einem Substrat (10);
- Abscheiden einer nicht organisierten Block-Copolymer-Schicht (20) auf der Führungsoberfläche (11), wobei die nicht organisierte Block-Copolymer-Schicht (20) geeignet ist, nach der Organisation ein nanostrukturiertes Block-Copolymer in der Form von Nanodomänen (21, 22) zu bilden;
- Bilden einer vernetzten Polymerschicht (TC) über der nicht organisierten Block-Copolymer-Schicht (20); wobei die Bildung einer vernetzten Polymerschicht (TC) über der nicht organisierten Block-Copolymer-Schicht (20) die folgenden Unterschritte umfasst:

  - Abscheiden einer ersten Schicht aus einer Vorpolymerzusammensetzung (prä-TC) auf der nicht organisierten Block-Copolymer-Schicht (20);
  - lokale Vernetzungsreaktion der Molekülketten in der ersten Schicht aus Vorpolymerzusammensetzung, derart dass eine lokal vernetzte Polymerschicht (TC1) erzeugt wird;
  - Spülen der lokal vernetzten Polymerschicht (TC1), um die nicht vernetzten Zonen zu entfernen;
  - Abscheiden einer zweiten Schicht aus einer Vorpolymerzusammensetzung (TC2) mindestens auf der nicht organisierten Block-Copolymer-Schicht (20);
  - lokale Vernetzungsreaktion der Molekülketten in der zweiten Schicht aus einer Vorpolymerzusammensetzung (TC2), derart dass eine vernetzte Polymerschicht (TC) erzeugt wird,
  - oder
- das Bilden einer vernetzten Polymerschicht (TC) über der nicht organisierten Block-Copolymer-Schicht (20) die folgenden Unterschritte umfasst:

  - Abscheiden einer Schicht aus Vorpolymerzusammensetzung, die einerseits eine Vielzahl von funktionellen Monomeren und mindestens eine in ihrer Polymerkette vernetzbare funktionelle Gruppe und andererseits zwei chemisch unterschiedliche Vernetzungsmittel umfasst, wobei jedes Mittel geeignet ist, die Vernetzung des Vorpolymers als Reaktion auf eine ihr eigene Stimulation einzuleiten, und
  - Vornehmen zweier aufeinanderfolgender Vernetzungen in Primär- (TC1) und Sekundärzonen (TC2) der Schicht durch aufeinanderfolgende Stimulation der zwei Vernetzungsmittel, um eine Vernetzungsreaktion der Molekülketten des Vorpolymers durch aufeinanderfolgende Wirkung des ersten Vernetzungsmittels in den Primärzonen, die der ersten Stimulation ausgesetzt werden, und dann des zweiten Vernetzungsmittels in den Sekundärzonen, die der zweiten Stimulation unterzogen werden, zu bewirken, um eine vernetzte Polymerschicht zu erhalten, in der die verschiedenen vernetzten Primär- (TC1) und Sekundärzonen (TC2) eine entgegengesetzte Affinität gegenüber den Blöcken des darunterliegenden Block-Copolymers aufweisen,
  - Ausglühen bei einer Temperatur, die der Organisationstemperatur (Tass) der nicht organisierten Block-Copolymer-Schicht (20) entspricht;
  - Entfernen der vernetzten Polymerschicht (TC) und eines der Copolymer-Blöcke mit nanostrukturierten Blöcken, derart dass Motive einer Nanolithographiemaske gebildet werden;
  - Ätzen des Substrats (10) mittels der Nanolithographiemaske,

wobei das Verfahren **dadurch gekennzeichnet ist, dass**:

- die Führungsoberfläche (11) gegenüber der nicht organisierten Block-Copolymer-Schicht (20) neutrale Zonen und nicht neutrale Zonen umfasst, wobei mindestens eine der neutralen oder nicht neutralen Zonen der Führungsoberfläche eine erste Abmessung aufweist;
- die vernetzte Polymerschicht (TC) gegenüber der nicht organisierten Block-Copolymer-Schicht (20) neutrale Zonen (TC1) und nicht neutrale Zonen (TC2) umfasst, wobei mindestens eine der nicht neutralen Zonen (TC2) der vernetzten Polymerschicht (TC) eine zweite Abmessung aufweist;
- das Entfernen eines der Blöcke ein Entfernen lediglich eines Teils der Nanodomänen (21, 22) eines der Blöcke des nanostrukturierten Block-Copolymers, insbesondere lediglich der Nanodomänen ist, die senkrecht (Z1) zu dem Block sind, derart dass die Nanodomänen (21, 22), die parallel zu mindestens zwei Blöcken des nanostrukturierten Block-Copolymers sind, Motive der Nanolithographiemaske bilden; und
- die erste und die zweite Abmessung unterschiedlich sind, derart dass nach dem Ätzen in der Nanolithographiemaske Motive (M1, M2, M3) mit unterschiedlichen Abmessungen und Nanostrukturen in dem nanostrukturierten Substrat mit unterschiedlichen Abmessungen erzeugt werden.

2. Verfahren nach Anspruch 1, **dadurch gekennzeichnet, dass** die nicht vernetzte Block-Copolymer-Schicht (20) eine Dicke von mindestens gleich 10 nm aufweist.

3. Verfahren nach Anspruch 1 oder 2, **dadurch gekennzeichnet, dass** die vernetzte Polymerschicht (TC) mindestens eine nicht neutrale Zone mit einer Abmessung aufweist, die sich von derjenigen der neutralen Zone unterscheidet.

4. Verfahren nach einem der vorhergehenden Ansprüche, **dadurch gekennzeichnet, dass** die Erzeugung einer Führungsoberfläche (11) über einem Substrat (10) die Durchführung einer Chemo-Epitaxie oder einer Grapho-Epitaxie beinhaltet.

5. Verfahren nach Anspruch 4, **dadurch gekennzeichnet, dass** die Führungsoberfläche (11) Führungsharz-Überdicken umfasst, und dadurch, dass die Überdicken Ätzeigenschaften aufweisen, die einem der Blöcke des Block-Copolymers ähnlich sind.

6. Verfahren nach Anspruch 5, **dadurch gekennzeichnet, dass** das Führungsharz, das die Überdicken bildet, gegenüber dem Block-Copolymer (20) nicht neutral ist.

7. Verfahren nach Anspruch 5, **dadurch gekennzeichnet, dass** das Führungsharz, das die Überdicken bildet, gegenüber dem Block-Copolymer (20) neutral ist.

8. Verfahren nach einem der Ansprüche 5 bis 7, **dadurch gekennzeichnet, dass** das Ätzen des Führungsharzes gemäß einem positiven Modus ausgeführt wird.

9. Verfahren nach einem der Ansprüche 5 bis 7, **dadurch gekennzeichnet, dass** das Ätzen des Führungsharzes gemäß einem negativen Modus ausgeführt wird.

10. Verfahren nach Anspruch 1, **dadurch gekennzeichnet, dass** die Zonen des Block-Copolymers, die sich unter den neutralen Zonen der vernetzten Polymerschicht befinden, Nanodomänen aufweisen, die senkrecht zu den Grenzflächen ausgerichtet sind, und die Abmessung der Nanodomänen der ersten Abmessung der nicht neutralen Zonen entspricht.

11. Verfahren nach Anspruch 1, **dadurch gekennzeichnet, dass** die Zonen des Block-Copolymers, die sich unter den nicht neutralen Zonen der vernetzten Polymerschicht befinden, Nanodomänen aufweisen, die parallel zu den Grenzflächen ausgerichtet sind, und die Abmessung der Nanodomänen der ersten Abmessung der nicht neutralen Zonen entspricht.

12. Verfahren nach einem der vorhergehenden Ansprüche 1 bis 11, **dadurch gekennzeichnet, dass** das Block-Copolymer in den gesamten (Co)monomeren, die den Block bilden, oder in einem Teil davon mindestens einen Block mit einem Heteroatom, wie beispielsweise Silizium, Germanium, Titan, Hafnium, Zirkon, Aluminium, umfasst.

13. Verfahren nach einem der Ansprüche 1 bis 12, **dadurch gekennzeichnet, dass** die vernetzte Polymerschicht (TC) mindestens zwei nicht neutrale Zonen mit unterschiedlichen Abmessungen aufweist.

## Claims

1. Method for nanostructuring a substrate (10) for the preparation of a nanostructured substrate having nanostructures of different dimensions, said process comprising the following steps:

    - generating a guiding surface (11) above a substrate (10);
    - depositing a layer (20) of unassembled block copolymer on the guiding surface (11), said layer (20) of unassembled block copolymer being able to form, after assembly, a nanostructured block copolymer in the form of nanodomains (21, 22) ;

- forming a crosslinked polymeric layer (TC) above the layer (20) of unassembled block copolymer; the forming of a crosslinked polymeric layer (TC) above the layer (20) of unassembled block copolymer comprises the following sub-steps:

  - depositing a first layer of a prepolymer composition (pre-TC) on the layer (20) of unassembled block copolymer;
  - local crosslinking reaction of molecular chains within said first layer of prepolymer composition, so as to generate a locally crosslinked polymeric layer (TC1);
  - rinsing the locally crosslinked polymeric layer (TC1) in order to remove the non-crosslinked zones;
  - depositing a second layer of a prepolymer composition (TC2) at least on the layer (20) of unassembled block copolymer;
  - local crosslinking reaction of molecular chains within said second layer of a prepolymer composition (TC2) so as to generate a crosslinked polymeric layer (TC).
  - or
- the forming of a crosslinked polymeric layer (TC) above the layer (20) of unassembled block copolymer comprises the following sub-steps:

  - depositing a layer of prepolymer composition comprising on the one hand, a plurality of functional monomers and at least one crosslinkable functional group within its polymer chain and, on the other hand, two chemically different crosslinking agents, each agent being able to initiate the crosslinking of said prepolymer in response to a stimulation which is specific to it, and
  - carrying out two successive crosslinkings in primary (TC1) and secondary (TC2) zones of said layer, by successive stimulation of the two crosslinking agents, in order to cause a crosslinking reaction of the molecular chains of said prepolymer by successive action of the first crosslinking agent in said primary zones subjected to said first stimulation and then of the second crosslinking agent in said secondary zones subjected to said second stimulation in order to obtain a crosslinked polymeric layer in which the different primary (TC1) and secondary (TC2) crosslinked zones have an opposite affinity with respect to the blocks of the underlying block copolymer.

- annealing at a temperature corresponding to the assembly temperature (Tass) of the layer (20) of unassembled block copolymer;
- removing the crosslinked polymeric layer (TC) and one of the blocks of the nanostructured block copolymer, so as to form patterns of a nano-lithography mask;
- etching the substrate (10) by means of said nano-lithography mask,

said method being **characterised in that**:

  - said guiding surface (11) comprises neutral zones and non-neutral zones with respect to the layer (20) of unassembled block copolymer, at least one of said neutral or non-neutral zones of the guiding surface having a first dimension;
  - said crosslinked polymeric layer (TC) comprises neutral zones (TC1) and non-neutral zones (TC2) with respect to the layer (20) of unassembled block copolymer, at least one of said non-neutral zones (TC2) of the crosslinked polymeric layer (TC) having a second dimension;
  - said removing of one of the blocks being a removing of only a part of the nanodomains (21, 22) of one of the blocks of the nanostructured block copolymer, in particular of only the perpendicular nanodomains (Z1) of said block, so that the parallel nanodomains (21, 22) of at least two blocks of the nanostructured block copolymer form patterns of the nano-lithography mask; and
  - said first and second dimensions are different so as to generate, in the nano-lithography mask, patterns (M1, M2, M3) of different dimensions and nanostructures in the nanostructured substrate of different dimensions after etching.

2. Method according to claim 1, **characterised in that** the layer (20) of non-crosslinked block copolymer has a thickness at least equal to 10 nm.

3. Method according to claim 1 or 2, **characterised in that** the crosslinked polymeric layer (TC) has at least one non-neutral zone of different dimension from that of the neutral zone.

4. Method according to one of the preceding claims, **characterised in that** the generation of a guiding surface (11) above a substrate (10) involves the implementation of a chemical epitaxy or a graphoepitaxy.

**5.** Method according to claim 4 **characterised in that** the guiding surface (11) comprises excess thicknesses of guiding resin and **in that** the excess thicknesses have etching properties similar to one of the blocks of the block copolymer.

**6.** Method according to claim 5 **characterised in that** the guiding resin forming the excess thicknesses is non-neutral with respect to the block copolymer (20).

**7.** Method according to claim 5 **characterised in that** the guiding resin forming the excess thicknesses is neutral with respect to the block copolymer (20).

**8.** Method according to one of claims 5 to 7 **characterised in that** the etching of the guiding resin is carried out in a positive mode.

**9.** Method according to one of claims 5 to 7, **characterised in that** the etching of the guiding resin is carried out in a negative mode.

**10.** Method according to claim 1, **characterised in that** the zones of the block copolymer located under the neutral zones of the crosslinked polymeric layer have nanodomains oriented perpendicular to the interfaces and the dimension of the nanodomains corresponds to the first dimension of the non-neutral zones.

**11.** Method according to claim 1, **characterised in that** the zones of the block copolymer located under the non-neutral zones of the crosslinked polymeric layer have nanodomains oriented parallel to the interfaces and the dimension of the nanodomains corresponds to the first dimension of the non-neutral zones.

**12.** Method according to any one of claims 1 to 11, **characterised in that** the block copolymer comprises at least one block with a heteroatom, such as silicon, germanium, titanium, hafnium, zirconium, aluminium, in all or part of the constituent (co)monomers of said block.

**13.** Method according to any one of claims 1 to 12, **characterised in that** the crosslinked polymeric layer (TC) has at least two non-neutral zones of different dimensions.

**FIG. 1**

(Art Antérieur)

**FIG. 2**

FIG. 3

EP 4 078 291 B1

FIG. 4

23

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3074180
- FR 3074179
- US 2015261090 A1

**Littérature non-brevet citée dans la description**

- **YUTAKA NAGATA et al.** *Macromolecules,* 2005, vol. 38 (24), 10220-10225
- **JIA et al.** *Journal of Macromolecular Science,* 2011, vol. 50, 1042
- **Y. ZHAO ; E. SIVANIAH ; T. HASHIMOTO.** *Macromolecules,* 2008, vol. 41 (24), 9948-9951